# EUROPEAN PATENT APPLICATION

(11) **EP 2 117 026 A1**
(43) Date of publication of application: **11.11.2009**
(21) Application number: 08711072.2
(22) Date of filing: 08.02.2008
(51) Int. Cl.: H01H 36/00

(54) **MAGNETIC SENSOR MODULE AND PISTON POSITION DETECTING DEVICE**

(30) Priority: 26.02.2007 JP 2007045295; 20.07.2007 JP 2007189692
(71) Applicant: Fujikura, Ltd., Tokyo 135-8512 (JP)
(72) Inventor: ITOI, Kazuhisa, Sakura-shi Chiba 285-8550 (JP); NAGASU, Katsubumi, Sakura-shi Chiba 285-8550 (JP); AIZAWA, Takuya, Sakura-shi Chiba 285-8550 (JP); NAKAO, Osamu, Sakura-shi Chiba 285-8550 (JP)
(74) Representative: Cabinet Plasseraud
(86) International application number: PCT/JP2008/052193
(87) International publication number: WO 2008/105228

(57) **Abstract**

A magnetic sensor module which includes: a semiconductor substrate including an integrated circuit for switching operation; a magneto-resistive element which is disposed on a first surface of the semiconductor substrate and has a magneto-sensitive direction in a direction along the first surface; and a bias magnetic field applying member provided on the semiconductor substrate and disposed on a surface which is parallel to the first surface, wherein: the bias magnetic field applying member is magnetized in a direction along the surface on which the bias magnetic field applying member is disposed; and when no external magnetic field is applied, the bias magnetic field applying member applies a bias magnetic field in the direction along the first surface on which the magneto-resistive element is provided.

## Description

### BACKGROUND OF THE INVENTION

### Field of the Invention

The present invention relates to a magnetic sensor module and a piston position detector which detects a piston's position in a cylinder tube. More particularly, the present invention relates to a piston position detector which detects a piston's position in a fluid pressure cylinder, such as a hydraulic cylinder and an air cylinder, from the outside of the cylinder tube.
This application claims priority of Japanese Patent Application Nos. 2007-045295 filed February 26, 2007 and 2007-189692 filed July 20, 2007, which are incorporated herein by reference in their entirety.

### Background Art

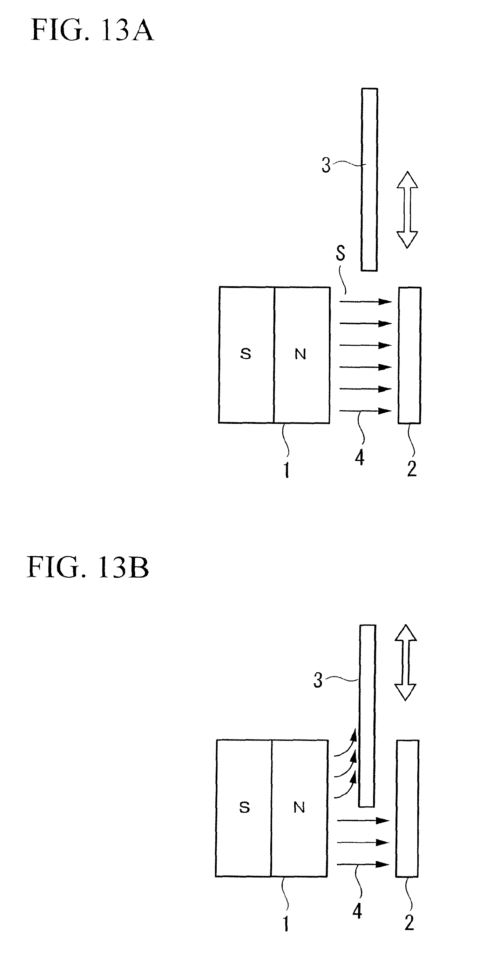

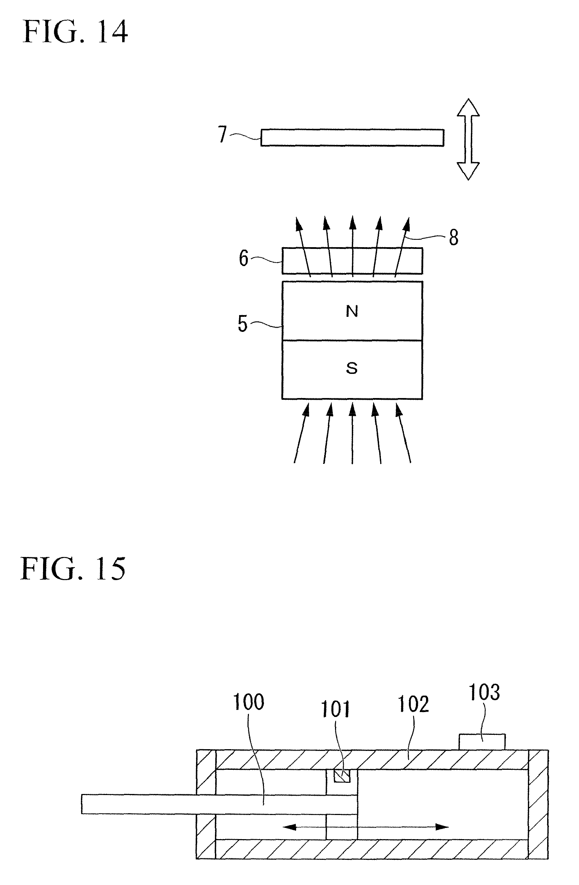

Magnetic sensors detect magnetic flux density and are used as opening/closing sensors or proximity sensors which are located near a magnetic material such as an iron sheet. The conventional magnetic sensors usually include a Hall sensor as a magneto-electric transducer. When used as proximity sensors, the conventional magnetic sensors may often be structured as shown in FIGS. 13A, 13B and 14. (see Patent Documents 1 to 3, and Non Patent Documents 1 to 3, for example)

The magnetic sensors used as proximity sensors shown in FIGS. 13A and 13B have the following structure. As shown in FIG. 13A, a magnet 1 is disposed so as to oppose a Hall element (or a Hall IC having a switching function) 2 such that magnetic flux 4 passes through the Hall element 2 perpendicularly to the longitudinal direction of the Hall element 2. When a magnetic material 3 approaches the magnetic sensor, the magnetic flux 4 is absorbed by the magnetic material 3 as shown in FIG. 13B and, accordingly, the magnetic flux density applied to the Hall element 2 decreases. Thereby, the approach of the magnetic material 3 can be detected by detecting changes in an output of the Hall element 2. In case of the Hall IC having a switching function, a predetermined magnetic flux density is considered as a threshold value, and an output which is inverted at the threshold value can be obtained.
A magnetic sensor used as a proximity sensor shown in FIG. 14 may operate similarly. In this magnetic sensor, a magnet 5 is disposed so as to oppose a Hall element (or a Hall IC having a switching function) 6 such that magnetic flux 8 passes through the Hall element 6 perpendicularly to the longitudinal direction of the Hall element 6. With this magnetic sensor, changes in an output in accordance with the distance from an approaching magnetic material 7 can be obtained.

These related art magnetic sensors incorporating the Hall element, however, may suffer from the following defects.
(1) Since the Hall elements 2, 6 and the magnets 1, 5 must be paired together, the number of components is increased and thus the magnetic sensor becomes large (Patent Document 2, for example). Especially in the structures shown in FIGS. 13A and 13B, a slit S through which the magnetic material 3 passes must be defined between the magnet 1 and the Hall element 2 (Non Patent Document 2, for example).
(2) The magnet for applying a bias magnetic field and the Hall element must be aligned with each other (Patent Document 3 for preventing variation, for example).
(3) Since the magnets have a wide variation of magnetic characteristics, the magnetic sensor must be designed expecting such variation (Patent Document 3 for preventing variation, for example).

A structure of a related art piston position detector is shown in FIG. 15 (Patent Document 4, for example). A magnet 101 is provided in a piston 100. A magnetic sensor 103 (with no magnet) is provided on an outside of a cylinder tube 102 which is made of a nonmagnetic material. When the magnet 101 approaches the magnetic sensor 103 with the movement of the piston 100, the magnetic sensor 103 may detect the magnet 101 and thus detect the position of the piston 100.

In such conventional piston position detector as described above, however, since the magnet must be provided in the piston, the structure of the piston inevitably becomes complicated and thus a manufacturing process thereof increases.
Thus, the cylinder must be designed considering characteristics of the magnet and the magnetic sensor. In concrete terms, whether the magnetic sensor of the Hall element or the magnetic sensor of the magneto-resistive element (i.e., the MR element) must be employed is determined depending on the orientation of the magnetic flux that may be vertical or parallel to the longitudinal direction of the cylinder tube. If the magneto-resistive element is used, the magnetic flux direction and the magneto-sensitive direction of the magnetic sensor must be aligned to one another. In contrast, if the magnetic sensor has already been selected, the direction of the magnetic pole of the magnet must be carefully determined. Furthermore, since the magnet must be provided in the piston, the piston and the cylinder tube inevitably become large.
Patent Document 1: Japanese Unexamined Patent Application, Publication No. 61-172075
Patent Document 2: Japanese Unexamined Patent Application, Publication No. 6-76706
Patent Document 3: Japanese Unexamined Patent Application, Publication No. 2004-186040
Patent Document 4: Japanese Patent No. 2616783
Non Patent Document 1: YAMADA Takeyoshi, "Highly Heat-Resistant Non-Contact Proximity Switch Developed by Tyco Electronics AMP K.K., Turning ON/OFF with Magnetic Field Disorder," October 5, 2006, Nikkei electronics, <URL: http://techon.nikkeibp.co.jp/article/NEWS/20061005/121974/> (searched February 6, 2007)
Non Patent Document 2: "Iron Sheet Proximity Switch ME-301," produced by NA K.K., <URL: http://www.na-web.co.jp/products/me/pr_02_21.html> (searched February 6, 2007)
Non Patent Document 3: TAKEUCHI Shotaro, IMANO Hideto, TOMOTSUNE Kaoru, WAKITSUBO Tsutomu and MAEDA Yutaka, "MR sensor module," NEC Technical Journal, NEC Corporation, 1998, Vol. 51, No. 4, pp 106-110.)

In view of the above circumstances, it is an object of the present invention to provide a magnetic sensor module with reduced variation in magnetic characteristics and in which a bias magnetic field applying member (e.g., a magnet) can be easily positioned with high accuracy. Another object of the present invention is to provide a piston position detector which eliminates the need for providing a bias magnetic field applying member in the piston and has a simple piston structure which may be manufactured in a simple process.

### SUMMARY OF THE INVENTION

In order to solve the above-described problems, a magnetic sensor module of the present invention includes: a semiconductor substrate including an integrated circuit for switching operation; a magneto-resistive element which is disposed on a first surface of the semiconductor substrate and has a magneto-sensitive direction in a direction along the first surface; and a bias magnetic field applying member provided on the semiconductor substrate and disposed on a surface which is parallel to the first surface, wherein: the bias magnetic field applying member is magnetized in a direction along the surface on which the bias magnetic field applying member is disposed; and in a state with no external magnetic field is applied, the bias magnetic field applying member applies a bias magnetic field in the direction along the first surface on which the magneto-resistive element is provided.

In the magnetic sensor module, the bias magnetic field applying member may preferably be a pasted magnet or a thin film magnet.
The integrated circuit may preferably compare output voltage of the magneto-resistive element with a predetermined threshold and output a signal indicating that the output voltage of the magneto-resistive element being larger than the predetermined threshold, i.e., in a high level state, or a signal indicating that the output voltage of the magneto-resistive element being smaller than the predetermined threshold, i.e., in a low level state, according to a comparison result.
The bias magnetic field applying member may preferably be disposed on another surface opposite to the first surface of the semiconductor substrate.
Furthermore, a piston position detector of the present invention includes: a cylinder tube made of a nonmagnetic material; a piston at least partially made of a magnetic material and is disposed to slide on an inner circumferential surface of the cylinder tube; and a magnetic sensor which is arranged on an outer circumferential surface of the cylinder tube and includes a bias magnetic field applying member.
The magnetic sensor may preferably include at least an integrated circuit which performs a switching operation based on the magnitude of the magnetic flux density; and the bias magnetic field applying member may preferably be a thin film magnet which is disposed on an upper surface, a lower surface, or an inside of the integrated circuit.
The magnetic sensor may preferably include a semiconductor substrate and a magneto-resistive element which is disposed on a first surface of the semiconductor substrate and has a magneto-sensitive direction in the direction along the first surface; the bias magnetic field applying member may preferably be a magnet which is provided on the semiconductor substrate and is disposed on a surface which is parallel to the first surface; the magnet may preferably be magnetized in the direction along the surface on which the magnet is disposed; and in a state with no external magnetic field is applied, the magnet may preferably apply a bias magnetic field in a direction along the first surface on which the magneto-resistive element is provided.

The magnetic sensor module according to the present invention has an integrated structure including the magneto-resistive element (i.e., the MR element), the semiconductor substrate (i.e., the MR switch) provided with an integrated circuit (IC) for a switching operation, and the bias magnetic field applying member. With this configuration, the present invention has the following advantages:
(1) Since the bias magnetic field applying member is included in the magnetic sensor module to form an integrated structure, the need to provide individual bias magnetic field applying members is eliminated.
(2) Since the direction of the magnetic field to be applied is parallel to the surface of the semiconductor substrate, the magnetic sensor module can be made compact.
(3) Since the bias magnetic field applying member can be formed in a process that is highly compatible with the semiconductor process, the need to align the bias magnetic field applying member with the semiconductor substrate is eliminated. Since the distance between the bias magnetic field applying member and the magneto-resistive element can be controlled with high accuracy, variation in the magnetic field to be applied can be reduced.
Furthermore, according to the present invention, since at least part of the piston is made of the magnetic material and the magnetic sensor includes the bias magnetic field applying member, the need to provide the bias magnetic field applying member in the piston is eliminated. With this configuration, the magnetic sensor can be mounted without consideration of the magnetic poles of the bias magnetic field applying member. In addition, since no bias magnetic field applying member is provided in the piston, the piston and cylinder tube can be made narrower. Accordingly, the present invention can provide a piston position detector with a simplified piston structure which can be manufactured in a simple process.

### BRIEF DESCRIPTION OF THE DRAWINGS

FIG. 1 is a schematic cross-sectional view of an exemplary schematic structure of a magnetic sensor module according to an embodiment of the present invention.
FIG. 2 is a plan view of an exemplary structure of a magneto-resistive element.
FIG. 3A schematically illustrates a magnetic field with no external magnetic field being applied to the magnetic sensor module shown in FIG. 1.
FIG. 3B is a graph schematically illustrating an output of the magnetic sensor module shown in FIG. 1 to which no external magnetic field is applied.
FIG. 4A schematically illustrates a magnetic field in which a magnetic material is made to approach the magnetic sensor module shown in FIG. 1 toward a surface of a semiconductor substrate.
FIG. 4B is a graph schematically illustrating an output of the magnetic sensor module shown in FIG. 1 in which the magnetic material is made to approach the magnetic sensor module toward the surface of the semiconductor substrate.
FIG. 5A schematically illustrates a magnetic field in which a magnetic material is made to approach the magnetic sensor module shown in FIG. 1 toward a back surface of the semiconductor substrate.
FIG. 5B is a graph schematically illustrating an output of the magnetic sensor module shown in FIG. 1 in which the magnetic material is made to approach the magnetic sensor module toward the back surface side of the semiconductor substrate.
FIG. 6A is a cross-sectional view schematically illustrating the magnetic sensor module shown in FIG. 1 mounted onto a substrate via bumps to form a magnetic sensor.
FIG. 6B schematically illustrates a magnetic field in which the magnetic sensor module shown in FIG. 1 is mounted onto a substrate via bumps to form a magnetic sensor.
FIG. 7 is a cross-sectional view of an exemplary piston position detector according to an embodiment of the present invention.
FIG. 8 is a cross-sectional view of another exemplary piston position detector according to an embodiment of the present invention.
FIG. 9 is a cross-sectional view illustrating a magnetic sensor which is incorporated in the sensors shown in FIGS. 7 and 8.
FIG. 10 is a plan view of an exemplary structure of a magneto-resistive element.
FIG. 11A illustrates a magnetic field with no external magnetic field being applied to the magnetic sensor.
FIG. 11B is a graph showing a relationship between a magnetic field to be applied and voltage with no external magnetic field being applied to the magnetic sensor.
FIG. 12A illustrates a magnetic field with a magnetic material being made to approach a magnetic sensor.
FIG. 12B is a graph showing a relationship between a magnetic field to be applied and voltage with the magnetic material being made to approach the magnetic sensor.
FIG. 13A schematically illustrates an exemplary related art magnetic sensor.
FIG. 13B schematically illustrates an exemplary related art magnetic sensor.
FIG. 14 schematically illustrates another exemplary related art magnetic sensor.
FIG. 15 is a cross-sectional view of an exemplary related art piston position detector.

### Description of the Reference Numerals

10: magnetic sensor module, 11: semiconductor substrate, 11 a: first surface, 11b: another surface, 12: bias magnetic field applying member, 13: magneto-resistive element (MR element), 23: magnetic sensor, 31: piston position detector, 32: cylinder tube, 33: piston, 34: magnetic material, 40: magnetic sensor, 41: semiconductor substrate, 42: magneto-resistive element, 43: bias magnetic field applying member, 44: thin film magnet, 47: magnetic sensor module

### DESCRIPTION OF THE PREFERRED EMBODIMENTS

### First Embodiment

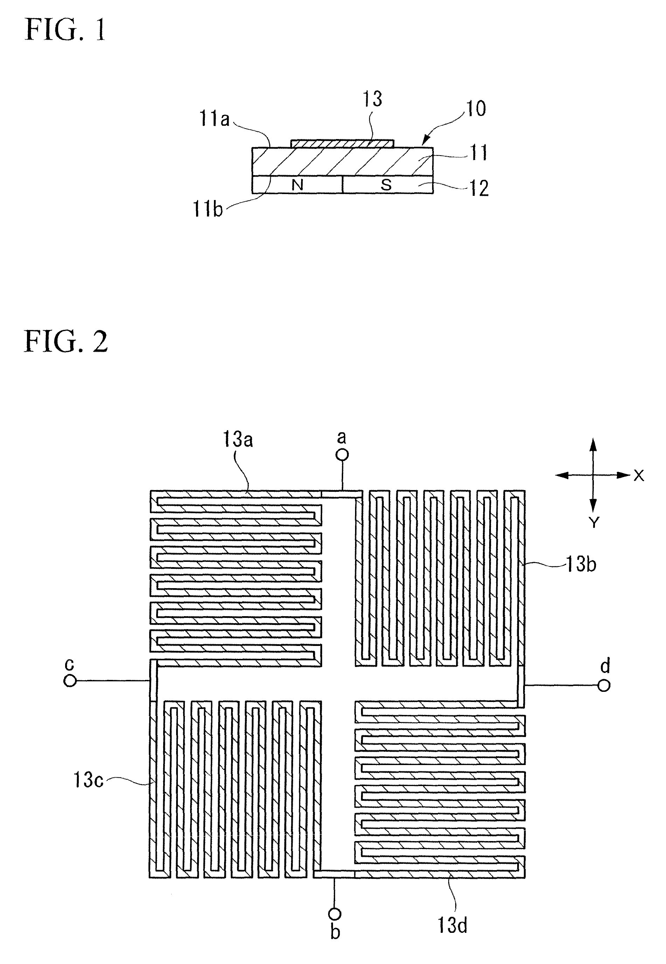

Hereinafter, a magnetic sensor module according to a first embodiment of the present invention will be described with reference to FIGS. 1 to 6B.
As described later, a magnetic sensor module 10 is mounted onto a substrate 22, such as a flexible printed circuit (FPC), via bumps or other members to form a magnetic sensor 23.

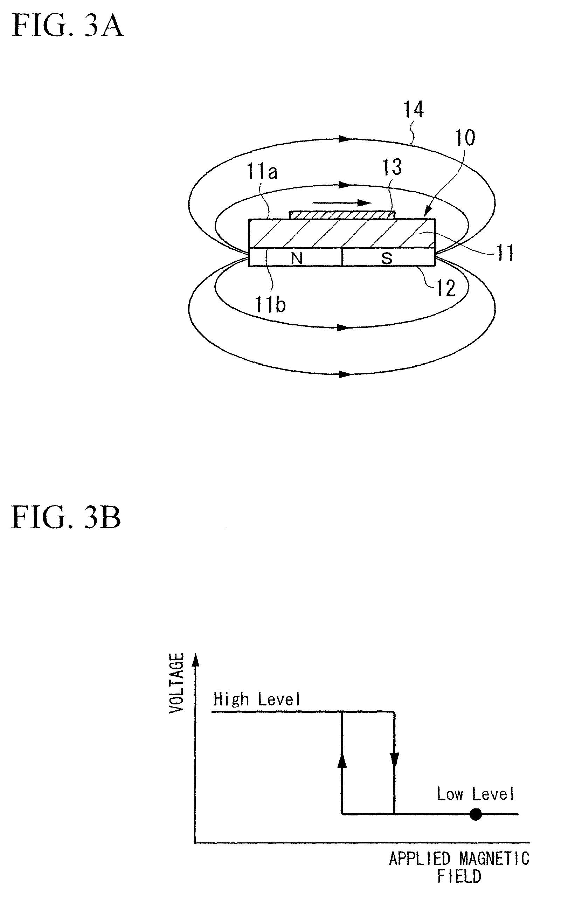

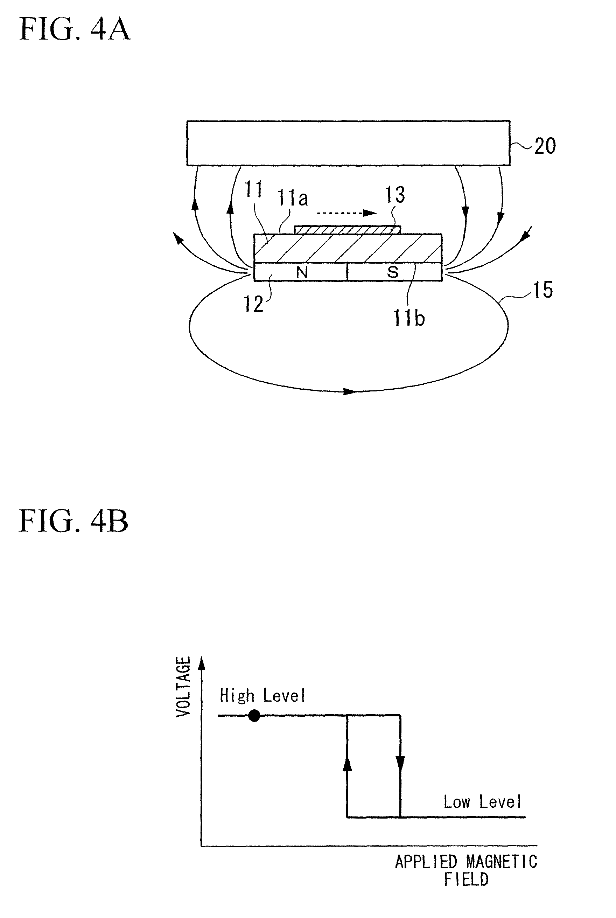

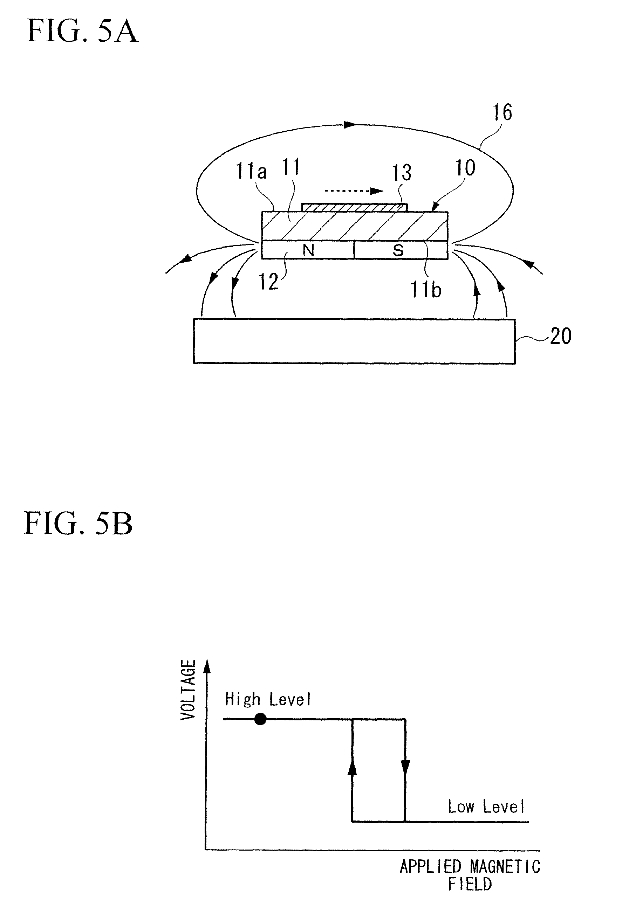

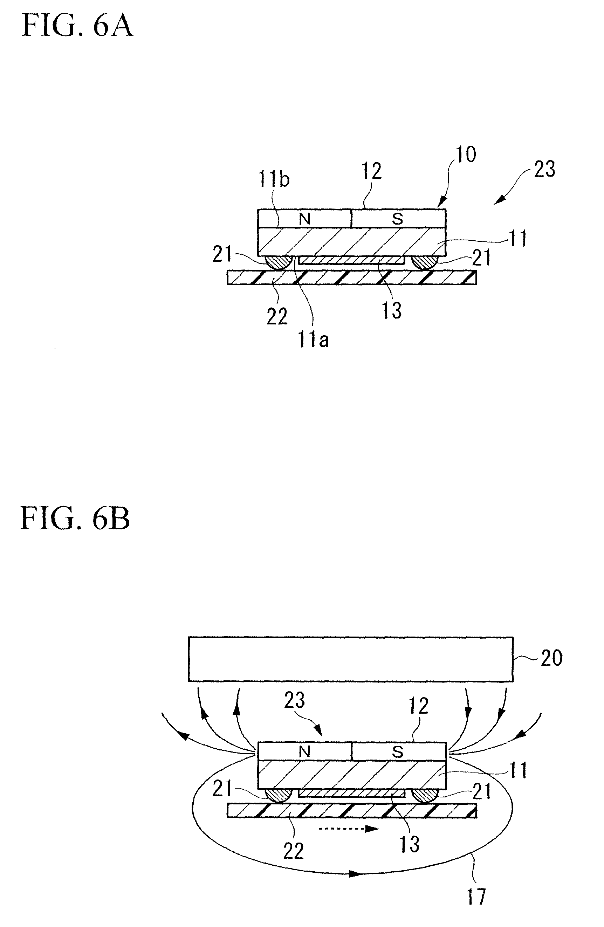

FIG. 1 is a schematic cross-sectional view of an exemplary schematic structure of the magnetic sensor module 10 according to the present embodiment of the present invention. FIG. 2 is a plan view of an exemplary structure of a magneto-resistive element 13. FIG. 3A schematically illustrates a magnetic field 14 with no external magnetic field being applied to the magnetic sensor module 10 shown in FIG. 1. FIG. 3B is a graph schematically showing an output in the state shown in FIG. 3A. FIG. 4A schematically illustrates a magnetic field 15 with a magnetic material 20 being made to approach the magnetic sensor module 10 shown in FIG. 1 toward a surface of a semiconductor substrate. FIG. 4B is a graph schematically showing an output in the state shown in FIG. 4A. FIG. 5A schematically illustrates a magnetic field 16 with the magnetic material 20 being made to approach the magnetic sensor module 10 shown in FIG. 1 toward a back surface of the semiconductor substrate. FIG. 5B is a graph schematically showing an output in the state shown in FIG. 5A. FIG. 6A is a cross-sectional view schematically illustrating the magnetic sensor module 10 shown in FIG. 1 mounted onto a substrate via bumps 21 to form the magnetic sensor 23. FIG. 6B schematically illustrates a magnetic field 17 in the state shown in FIG. 6A.

Reference numerals 14 to 17 in FIG. 3A, 4A, 5A and 6B each schematically denotes the magnetic field in each state. The graphs of FIGS. 3B, 4B and 5B schematically show that the output is in different horizontal positions in transition from a high level state to a low level state and in transition from the low level state to the high level state.

As shown in FIG. 1, the magnetic sensor module 10 at least includes a semiconductor substrate 11, a magneto-resistive element 13 and a bias magnetic field applying member (i.e., a magnet for applying a bias magnetic field) 12. The semiconductor substrate 11 includes an integrated circuit (not shown) for a switching operation. The magneto-resistive element 13 is provided on a first surface 11 a of the semiconductor substrate 11 and has a magneto-sensitive direction along the first surface 11a. The bias magnetic field applying member 12 is provided on the semiconductor substrate 11 and is disposed on a surface 11b which is parallel to the first surface 11a. The magnetizing direction of the bias magnetic field applying member 12 of the magnetic sensor module 10 according to the present embodiment corresponds to a direction along the surface 11b on which the bias magnetic field applying member 12 is formed. That is, the N-pole and the S-pole are disposed adjacent to each other along the surface 11b as shown in FIG. 3A. In a state with no external magnetic field being applied, the bias magnetic field 14 is applied along the direction of the first surface 11 a on which the magneto-resistive element 13 is formed.

Preferably, the bias magnetic field applying member 12 may be made of a pasted magnet or a thin film magnet which can be formed in a process that is highly compatible with the semiconductor process when being mounted onto the semiconductor substrate 11. A hard magnetic material which forms the magnet is not particularly limited, however, samarium-cobalt (SmCo), iron-platinum (FePt), cobalt-platinum (CoPt), neodymium-iron-boron (NdFeB) or ferrite or the like can be used, for example.

The pasted magnet may be provided by, for example, applying a hard magnetic material paste to either one of the surfaces of the substrate, sintering, heating and subsequently magnetizing in a predetermined direction. The hard magnetic material paste may be a mixture of hard magnetic material powder and binder resin.

The thin film magnet is a thin film of a hard magnetic material. The method of fabricating the thin film magnet is not particularly limited, however, sputtering, vapor deposition, plating or printing a bonded magnet or the like can be used, for example. The thin film magnet may be patterned into an arbitrary configuration by, for example, photolithography, such as etching and lifting off. The fabricated thin film magnet is annealed if necessary and then magnetized in a magneto-sensitive direction to form a magnetic sensor.

In the example shown in FIG. 1, the bias magnetic field applying member 12 is provided on the surface 11b which is opposite to the first surface 11 a of the semiconductor substrate 11. With this configuration, since the distance between the bias magnetic field applying member 12 and the magneto-resistive element 13 is determined by the thickness of the semiconductor substrate 11, the magnetic field to be applied to the magneto-resistive element 13 can be controlled with high accuracy.

The magnetic sensor module 10 of the present invention is not limited to the above described example. Alternatively, the bias magnetic field applying member 12 may be provided on the first surface 11a of the semiconductor substrate 11. The bias magnetic field applying member 12 may be mounted onto the semiconductor substrate 11 with any number of other layers (not shown) disposed therebetween. With this configuration, the distance between the bias magnetic field applying member 12 and the semiconductor substrate 11 can be controlled. According to this manner, the magnetic field to be applied to the magneto-resistive element 13 may be controlled with high accuracy. The other layers to be interposed are not particularly limited, however, these layers may be easily formed from a film made of a nonmagnetic material, such as an inorganic or organic material, for example.

In the present invention, an anisotropic magneto-resistive material (MR) is used as a magneto-electric transducer of the magneto-resistive element 13 which forms the magnetic sensor module 10. The anisotropic magneto-resistive material has a magneto-sensitive direction along a film surface thereof. The magneto-resistive element 13 may be formed from a ferromagnetic film of, a permalloy, such as iron-nickel (FeNi) and iron-nickel-cobalt (NiFeCo), for example.

In the present embodiment, the magneto-resistive element 13 provided on the semiconductor substrate 11 has a bridge structure which includes four MR thin film resistors 13a, 13b, 13c and 13d and electrically conductive terminals a, b, c and d provided between the MR thin film resistors 13a to 13d as shown in FIG. 2. Each of the MR thin film resistors 13a to 13d may be formed in a combined process of, a pattern formation by photolithography and a film formation by plating or sputtering, for example. The patterns of the MR thin film resistors 13a to 13d are oriented in predetermined directions.

In the magneto-resistive element 13 shown in FIG. 2, the MR thin film resistors 13a and 13d are disposed along a first direction (hereinafter, referred to as an "X direction," which is a horizontal direction in FIG 2), and the MR thin film resistors 13b and 13c are disposed along a direction perpendicular to the X direction on the first surface 11 a of the semiconductor substrate 11 (hereinafter, referred to as a "Y direction," which is a vertical direction in FIG. 2).

The MR thin film resistors 13a and 13d oriented in the X direction have multiple MR films disposed parallel to each other. The MR films are disposed with the longitudinal direction thereof being along the X direction. The MR films adjacent to each other are electrically connected in the Y direction via an MR film or a conductive film so that the adjacent MR films are connected as a meander (i.e., bent) at their ends.
The MR thin film resistors 13b and 13c oriented in the Y direction have multiple MR films disposed parallel to each other. The MR films are disposed with the longitudinal direction thereof being along the Y direction. The MR films adjacent to each other are electrically connected in the X direction via an MR film or a conductive film so that the adjacent MR films are connected as a meander (i.e., bent) at their ends.

The four MR thin film resistors 13a to 13d are preferably made of the same MR film material so that they have similar variation in temperature characteristics. With this configuration, the temperature characteristics of the magnetic device can be improved. If the meander section is made of a conductive film, the conductor film made of gold (Au), copper (Cu) or aluminum (Al) or the like may be used.

The magneto-resistive element 13 forms a bridge circuit as shown in FIG. 2. That is, in the MR thin film resistors 13a to 13d, adjacent resistors are oriented in different directions (i.e., the X or Y direction), and the four MR thin film resistors 13a to 13d are connected together via wiring. The wiring may be a conductor film made of gold (Au), copper (Cu) or aluminum (Al) or the like, for example. The adjacent resistors are disposed so as to change direction thereof at 90 degrees to each other. The MR thin film resistors 13a to 13d are preferably made of a similar material and patterned similarly and preferably have the same resistance value. The MR thin film resistors 13a to 13d may be arranged in 2 x 2 rows in vertical and horizontal directions as shown in FIG. 2. The MR thin film resistors 13a to 13d, however, may also be arranged in other ways so long as they are connected by suitable wiring.

In this bridge circuit, when power supply voltage is connected to the terminal a and the grand level is connected to the terminal b, an output of the magneto-resistive element 13 can be obtained as a potential difference (i.e., a bridge output) between two other terminals c and d. The bridge output is increased or decreased depending on the magnitude of the magnetic field to be applied. Accordingly, a switching operation may be performed through comparison of the magnitude of the bridge output (i.e., the voltage) with a predetermined threshold. In particular, the switching operation may be performed to determine whether the output voltage is larger than the threshold (high level state) or the output voltage is smaller than the threshold (low level state). In the present invention, the switching operation is performed by an integrated circuit (not shown) mounted onto the semiconductor substrate 11. The integrated circuit outputs signals indicating the high or low level state.

Next, a detection method of the magnetic sensor module 10 according to the present embodiment will be described with reference to FIGS. 3A to 5B. The output of the magnetic sensor module 10 is determined by a threshold magnetic flux density. In particular, the output voltage is in the high level state with the magnetic flux density being low and is the low level state with magnetic flux density being high. Accordingly, a threshold is set for the output voltage of the magnetic sensor module 10. Furthermore, the magnitude of the output of the magnetic sensor module 10 is determined to be in the high level state with the output voltage thereof being larger than the threshold and determined to be in the low level state with the output voltage thereof being smaller than the threshold. Preferably, the threshold may be determined with a sufficient difference between the high and low level states for a clear distinguishment. In the present embodiment, the integrated circuit that performs the switching operation through comparison of the voltage values is used in combination of the output of the magneto-electric transducer. In this manner, the magnetic sensor module 10 performs the switching operation based on the magnitude of the external magnetic field.

As shown in FIG. 3A, with no external magnetic field being applied, the bias magnetic field 14 is applied by the bias magnetic field applying member 12 to the magneto-resistive element 13 in the direction along the surface on which the magneto-resistive element 13 is formed. The bias magnetic field applying member 12 is magnetized in the direction along the surface on which the bias magnetic field applying member 12 is formed. The magnetic field 14 at this time has the high magnetic flux density near the magneto-resistive element 13 (indicated by a solid rightward arrow above the magneto-resistive element 13 in FIG. 3A). As shown in FIG. 3B, if the threshold is set to determine the output voltage at this time to be the low level state, the output of the low level state will represent the state with no magnetic material being made to approach the magnetic sensor module 10.

When the magnetic material 20, which is, for example, an iron sheet, is made to approach the bias magnetic field applying member 12 as shown in FIG. 4A, the magnetic flux applied from the bias magnetic field applying member 12 will be absorbed by the magnetic material 20. As a result, the magnetic field 15 at this time has a low magnetic flux density near the magneto-resistive element 13 (indicated by a dashed rightward arrow above the magneto-resistive element 13 in FIG. 4A). As shown in FIG. 4B, if the threshold is set to determine the output voltage at this time to be the high level state, the output of the high level state will represent the state with the magnetic material 20 being made to approach the magnetic sensor module 10.

FIG. 4A illustrates that the magnetic material 20 is made to approach the first surface 11 a of the semiconductor substrate 11. The magnetic sensor module 10, however, may also operate similarly if magnetic material 20 is made to approach the another surface 11b of the semiconductor substrate 11 as shown in FIG. 5A. In particular, if the magnetic material 20 is made to approach the another surface 11b, the magnetic flux applied from the bias magnetic field applying member 12 will be absorbed by the magnetic material 20. As a result, a weak magnetic field 16 with the low magnetic flux density is formed near the magneto-resistive element 13. The weak magnetic field 16 outputs a signal indicating the high level state with the magnetic material 20 being made to approach the magnetic sensor module 10.

The resistance value of the magneto-resistive element 13 varies according to the magnitude of the magnetic field to be applied. The resistance value of the magneto-resistive element 13 decreases as the magnetic field to be applied becomes stronger. Thus, the potential difference (i.e., the bridge output) between the two terminals of the magneto-resistive element 13 is increased or decreased depending on the magnitude of the magnetic flux density applied to the MR film. The bridge output is compared with a predetermined threshold to determine whether the output voltage is larger or smaller than the predetermined threshold, and then, the switching operation is performed in accordance with the comparison result. With this configuration, the magnetic sensor module 10 which generates two different outputs according to the magnitude of the magnetic flux density applied to the element can be obtained. The output of the magnetic sensor module 10 from the integrated circuit may be a signal indicating a high voltage value output when the bridge output of the magneto-resistive element 13 is smaller than the predetermined threshold, and a signal indicating a low voltage value output when the bridge output of the magneto-resistive element 13 is larger than the predetermined threshold. Alternatively, the output of the magnetic sensor module 10 from the integrated circuit may be a signal indicating a low voltage value when the bridge output of the magneto-resistive element 13 is smaller than the predetermined threshold, and a signal indicating a high voltage value when the bridge output of the magneto-resistive element 13 is larger than the predetermined threshold.

In this embodiment, since the integrated circuit (IC) mounted on the semiconductor substrate performs the switching operation, the circuit required for comparison and control can be formed in a small space, which may provide a compact magnetic sensor module 10. As shown in FIG. 6A, the magnetic sensor module 10 of the present embodiment may be fixed onto a substrate 22, such as a flexible printed circuit (FPC), via bumps 21 provided on the surface 11 a of the semiconductor substrate 11 to form the magnetic sensor 23. The magnetic sensor module 10, the bumps 21 and the substrate 22 may be housed in an unillustrated magnetic sensor housing, altogether constituting the magnetic sensor 23. In this case, the semiconductor substrate 11 and the circuit board 22 may be electrically connected by bumps, wires or conductive paste (not shown).

As described above, the first embodiment of the present invention includes the bias magnetic field applying member 12 which is magnetized in a direction along the surface in which is the bias magnetic field applying member 12 is formed and the magneto-resistive element 13 which has the magneto-sensitive direction in the direction along the film surface. With this configuration, the magnetic material 20 can be detected if made to approach the magnetic sensor module 10 from any direction.
Since the bias magnetic field applying member 12 and the magneto-resistive element 13 may be fabricated in a process that is highly compatible with a semiconductor process, the positional relationship of the bias magnetic field applying member 12 and the magneto-resistive element 13 may be aligned with high accuracy. Since the bias magnetic field applying member 12 and the magneto-resistive element 13 are integrally mounted on the semiconductor substrate, both the magnetic sensor module 10 and the magnetic sensor 23 provided with the magnetic sensor module 10 may be made compact.

### Example

The magnetic sensor module 10 fabricated in this example includes the magneto-resistive element 13 and the bias magnetic field applying member 12 integrated on the semiconductor substrate 11 as shown in FIG. 1. As shown in FIG. 2, the magneto-resistive element 13 has a bridge structure including the four MR thin film resistors 13a to 13d. Each MR thin film resistor is formed of a permalloy thin film. The output of the magneto-resistive element 13 is compared by the comparator in the integrated circuit for the subsequent switching operation. The package of the magnetic sensor module 10 is composed of a wafer level package (WLP) including a silicon (Si) substrate. The chip size including the bumps 21 (see FIGS. 6A and 6B) is 0.97 x 0.97 x 0.5 (mm).

An NdFeB-based pasted magnet is disposed at the back surface 11b of the semiconductor substrate 11 as the bias magnetic field applying member 12. The NdFeB-based pasted magnet has a thickness of about 80 micrometers and is magnetized in the direction along the same surface as the magneto-sensitive direction of the magneto-resistive element 13. Since the pasted magnet can control the magnetic field to be applied to the magneto-resistive element 13 according to the thickness thereof, and the distance between the bias magnetic field applying member 12 and the magneto-resistive element 13 is determined by the thickness of the substrate 11; the magnetic field to be applied can be controlled with high accuracy.

As shown in FIG. 6A, the magnetic sensor module 10 is mounted on the substrate 22 via the bumps 21 provided on the first surface 11a of the semiconductor substrate 11 to form the magnetic sensor 23. The output of the magnetic sensor 23 is measured and found to be in the low level state. The magnetic sensor 23 has a threshold magnitude of the magnetic field which is about 10 to 20 (Oe) with no bias magnetic field being applied thereto. The output of the magnetic sensor 23 is determined to be in a low level state when a magnetic field is stronger than the threshold and to be in a high level state when the magnetic field is weaker than the threshold. Accordingly, the low level state output means that the bias magnetic field of about 20 (Oe) is applied to the magnetic sensor 23.

Next, as shown in FIG. 6B, when the iron sheet as a magnetic material 20 is made to approach the bias magnetic field applying member 12 on the magnetic sensor module 10, the output of the magnetic sensor 23 is turned to the high level state at the distance of about 10 mm. This means that the magnetic flux density near the magneto-resistive element 13 decreases and the magnitude of the magnetic field to be applied becomes less than about 10 (Oe), as a result of the magnetic flux produced in the bias magnetic field applying member 12 being absorbed by the magnetic material 20.

Similarly, although not shown, when the magnetic material is made to approach the magneto-resistive element 13 (from below in FIGS. 6A and 6B) on the magnetic sensor module 10, the output of the magnetic sensor 23 is turned to the high level state.
These results show that the output which is turned to the high level state can be obtained when the magnetic material 20 is made to approach the magneto-resistive element 13 or the opposite side.

### Second Embodiment

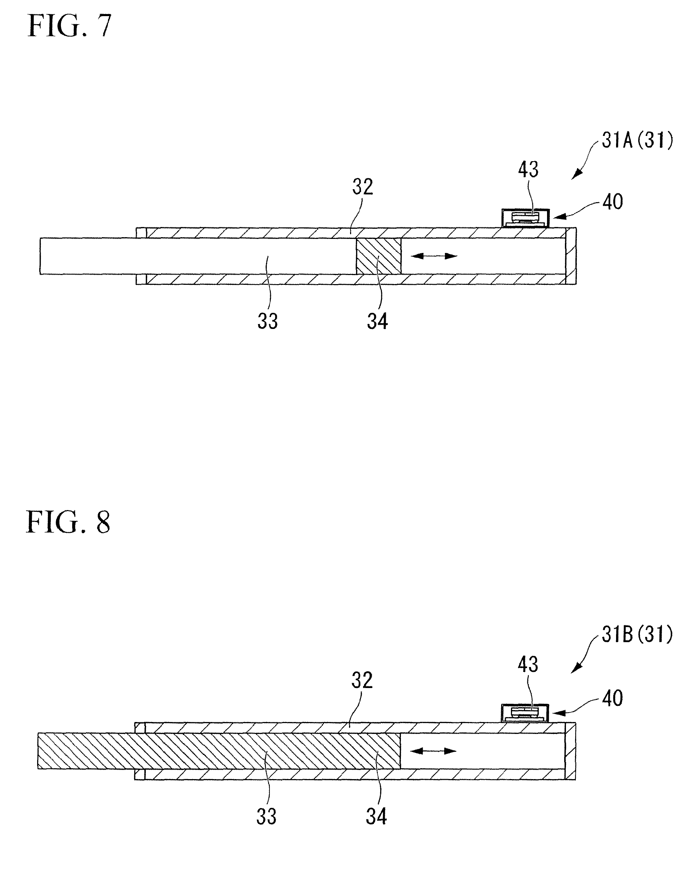

Hereinafter, a second embodiment of the present invention will be described with reference to FIGS. 7 to 12B.
That is, a piston position detector according to a second embodiment of the present invention will be described with reference to the drawings.

FIG. 7 is a longitudinal cross-sectional view schematically illustrating a piston position detector 31 according to an embodiment of the present invention.
The piston position detector 31 at least includes a cylinder tube 32 of a nonmagnetic material, a piston 33 and a magnetic sensor 40. The piston 33 is at least partially made of a magnetic material 34 and is disposed to slide on an inner circumferential surface of the cylinder tube 32. The magnetic sensor 40 is disposed on an outer circumferential surface of the cylinder tube 32. The magnetic sensor 40 includes at least a bias magnetic field applying member 43.

Since the piston 33 is partially made of the magnetic material 34 which can absorb the magnetic flux and the magnetic sensor 40 includes the bias magnetic field applying member 43, the need of a magnet to be disposed on the piston 33 is eliminated. Accordingly, the magnetic sensor 40 can be mounted without considering the magnetic poles. Since the piston 33 has no magnets disposed thereon, the piston 33 and the cylinder tube 32 can be made narrower. As a result, the piston position detector 31 according to the present embodiment has a simplified structure of the piston 33 and which may be made in a simple process.

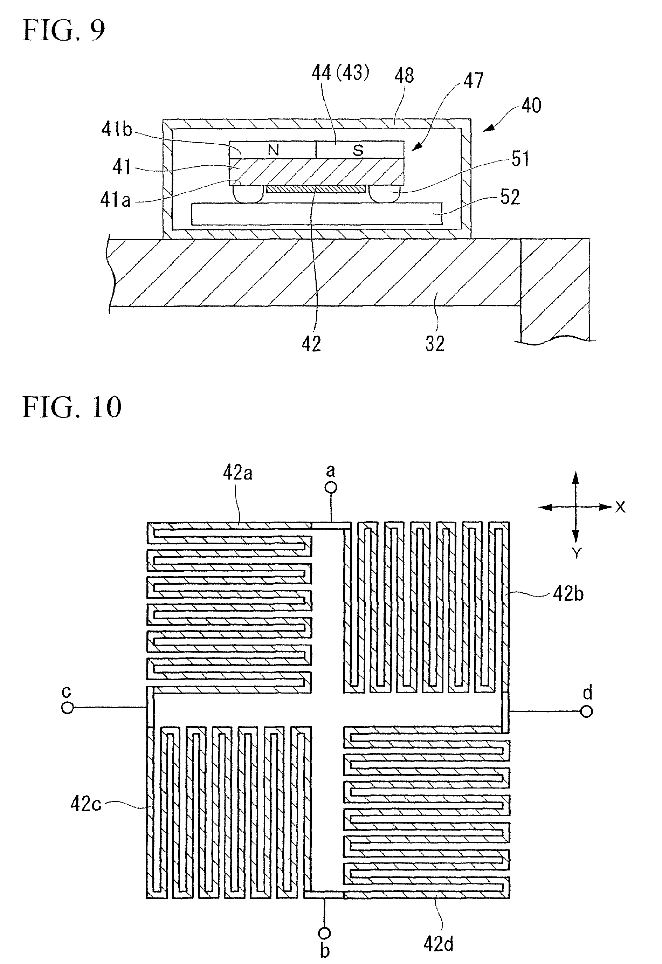

As shown in FIG. 9, which is a cross-sectional view of a part of the magnetic sensor 40, the magnetic sensor 40 includes a magnetic sensor module 47, bumps 51, a substrate 52 and a magnetic sensor housing 48 which houses these members, which will be described later. The magnetic sensor module 47 includes at least a semiconductor substrate 41, a magneto-resistive element 42 and a bias magnetic field applying member (i.e., a magnet for bias magnetic field application) 43. The semiconductor substrate 41 includes an integrated circuit which performs a switching operation according to the magnitude of the magnetic flux density. The magneto-resistive element 42 is provided on a first surface 41a of the semiconductor substrate 41 and has a magneto-sensitive direction along the first surface 41a. The bias magnetic field applying member 43 is provided on the semiconductor substrate 41 and is disposed on a surface 41b which is parallel to the first surface 41a. The bias magnetic field applying member 43 is a thin film magnet, which is disposed on an upper surface, a lower surface or the inside of the integrated circuit. With this configuration, the magnetic sensor 40 may be made compact, which increases the design degree of freedom of the piston position detector 31 and contributes to the compact design of the entire piston position detector 31.

The cylinder tube 32 is made of a nonmagnetic material. The nonmagnetic material is not particularly limited, however, a nonmagnetic metallic material such as stainless steel or copper and, a synthetic resin material such as polyethylene or polyvinyl chloride or the like can be used, for example.

The piston 33 is a rod-like member which is disposed inside of the cylinder tube 32 so as to slide on the inner circumferential surface of the cylinder tube 32.
The piston 33 is at least partially made of the magnetic material 34 which can absorb the magnetic flux. The magnetic material 34 is not particularly limited, however, a highly magnetic material, such as iron (Fe), niobium (Nb), chromium (Cr) or neodium (Nd) or the like can preferably be used, for example.

The entire piston 33 may be made of the magnetic material 34 as shown in FIG. 8, or alternatively, only a tip portion of the piston 33 may be made of the magnetic material 34 as shown in FIG. 7.

The magnetic sensor 40 is a magnetic proximity sensor disposed on an outer circumferential surface of the cylinder tube 32. As described later, the magnetic sensor 40 has a bridge structure which includes four MR thin film resistors. The magnetic sensor 40 performs the switching operation by comparing the outputs of the four MR thin film resistors by a comparator. The piston position detector 31 detects the piston's position through the switching operation.

As shown in FIG. 9, the magnetic sensor 40 has a structure in which the bumps 51 are provided on the surface 41a of the semiconductor substrate 41 and are fixed to the substrate 52, such as a flexible printed circuit (FPC). The magnetic sensor 40 is disposed on an outer circumferential surface of the cylinder tube 32. The semiconductor substrate 41 and the circuit board 52 may be electrically connected by the bumps 51, wires or conductive paste (not shown). The magnetic sensor 40 is packaged by a wafer level package (WLP). The chip size of the magnetic sensor module 47 including the bumps is 0.97 x 0.97 x 0.5 (mm). The magnetic sensor 40 may alternatively be packaged by a resin mold package.

An anisotropic magneto-resistive material (MR) is used as a magneto-electric transducer of the magneto-resistive element 42 of the magnetic sensor 40. The anisotropic magneto-resistive material has a magneto-sensitive direction along a film surface thereof. The magneto-resistive element 42 can be made from a film of a ferromagnetic material such as iron-nickel (FeNi) or iron-nickel-cobalt (NiFeCo), and is made of a permalloy, for example.

In the present embodiment, the magneto-resistive element 42 provided on the semiconductor substrate 41 has a bridge structure which includes four MR thin film resistors 42a, 42b, 42c and 42d and electrically conductive terminals a, b, c and d provided between the MR thin film resistors 42a to 42d as shown in FIG. 10. Each of the MR thin film resistors 42a to 42d may be formed in a combined process of, for example, a pattern formation by photolithography and a film formation by plating or sputtering. The patterns of the MR thin film resistors 42a to 42d are oriented in predetermined directions.

The magneto-resistive element 42 forms a bridge circuit as shown in FIG. 10. That is, in the MR thin film resistors 42a to 42d, adjacent resistors are oriented in different directions (i.e., the X or Y direction), and the four MR thin film resistors 42a to 42d are connected together via wiring. The wiring may be made of a conductor film, such as gold (Au), copper (Cu) or aluminum (Al) or the like, for example. The adjacent resistors are disposed so as to change direction thereof at 90 degrees to each other. The MR thin film resistors 42a to 42d are preferably made of a similar material, patterned similarly, and have the same resistance value. The MR thin film resistors 42a to 42d may be arranged in 2 x 2 rows in vertical and horizontal directions as shown in FIG. 10. The MR thin film resistors 42a to 42d, however, may also be arranged in other ways so long as they are connected by suitable wiring.

In this bridge circuit, when power supply voltage is connected to the terminal a and the grand level is connected to the terminal b, an output of the magneto-resistive element 42 can be obtained as a potential difference (i.e., a bridge output) between two other terminals c and d. The bridge output is increased or decreased depending on the magnitude of the magnetic field to be applied.
Accordingly, a switching operation may be performed through comparison of the magnitude of the bridge output (i.e., the voltage) with a predetermined threshold. In particular, the switching operation may be performed to determine whether the output voltage is larger than the threshold (high level state) or the output voltage is smaller than the threshold (low level state). In the present invention, the switching operation is performed by an integrated circuit (not shown) mounted onto the semiconductor substrate 41. The integrated circuit outputs signals indicating the high or low level state.

The bias magnetic field applying member 43 which forms part of the magnetic sensor 40 is disposed on an outside of the cylinder tube 32. In the example shown in FIG. 9, the bias magnetic field applying member 43 is mounted on the semiconductor substrate 41 in the magnetic sensor 40, and is disposed in the surface 41b which is parallel to the first surface 41a.

Preferably, the bias magnetic field applying member 43 may be made of a thin film magnet 44 which can be formed in a process that is highly compatible with the semiconductor process when being mounted onto the semiconductor substrate 41. A hard magnetic material which forms the thin film magnet 44 is not particularly limited, however, samarium-cobalt (SmCo), iron-platinum (FePt), cobalt-platinum (CoPt), neodymium-iron-boron (NdFeB) or ferrite or the like can be used, for example.

The thin film magnet 44 is a thin film of a hard magnetic material. A method of fabricating the thin film magnet 44 is not particularly limited, however, sputtering, vapor deposition, plating or printing a bonded magnet or the like can be used, for example. The thin film magnet 44 may be patterned into an arbitrary configuration by, for example, photolithography, such as etching or lifting off. The fabricated thin film magnet 44 is annealed if necessary and then magnetized in a magneto-sensitive direction to form a magnetic sensor.

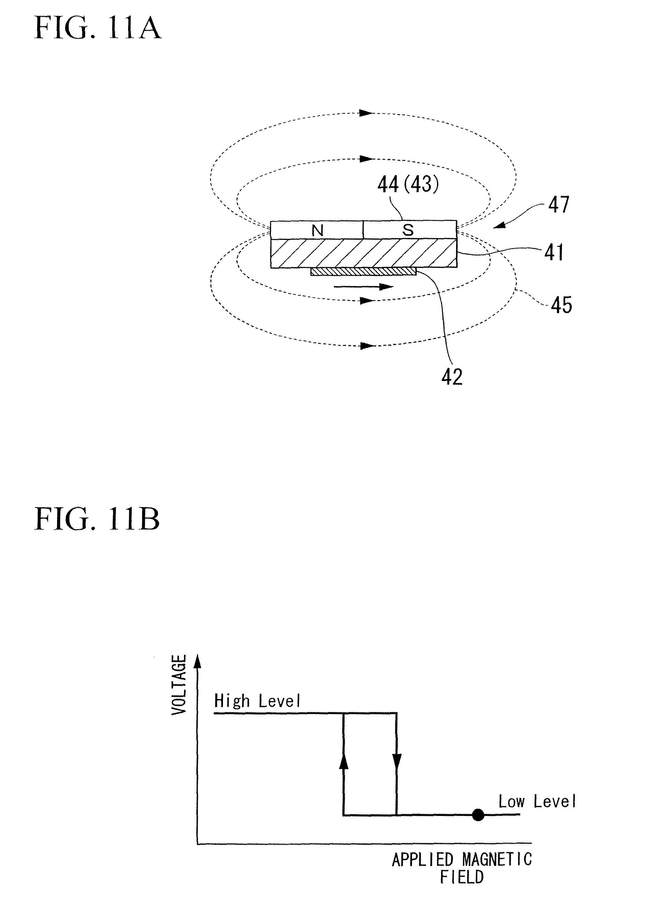

The thickness of the thin film magnet 44 or an area that the thin film magnet 44 occupies in the magnetic sensor module 47 is not particularly limited and may be determined suitably. For example, as a thin film magnet 44, an NdFeB-based pasted magnet is formed on the surface 41b of the semiconductor substrate 41 to the thickness of about 80 nm and is magnetized to the same direction of the magneto-sensitive direction of the magnetic sensor 40.
As shown in FIG. 11A, the thin film magnet 44 is magnetized in the direction along the surface 41b on which the magnet is formed (i.e., the magnetizing direction of the thin film magnet 44 is along the direction of the surface 41b). The bias magnetic field 45 is applied to the magnetic sensor 40 in the direction along the surface on which the magneto-resistive element 42 is formed when no external magnetic field is applied.

Here, in the example shown in FIG. 9, the bias magnetic field applying member 43 is provided on the another surface 41 b which is the opposite to the first surface 41 a of the semiconductor substrate 41. With this configuration, since the distance between the thin film magnet 44 and the magneto-resistive element 42 is determined by the thickness of the substrate 41, the magnetic field to be applied to the magneto-resistive element 42 can be controlled with high accuracy.

The arrangement of the bias magnetic field applying member 43 is not limited to the described example. The bias magnetic field applying member 43 may alternatively be provided on the first surface 41 a of the semiconductor substrate 41. The bias magnetic field applying member 43 may be mounted onto the semiconductor substrate 41 with any number of other layers (not shown) disposed therebetween. With this configuration, the distance between the bias magnetic field applying member 43 and the semiconductor substrate 41 can be controlled. According to this manner, the magnetic field to be applied to the magneto-resistive element 42 may be controlled with high accuracy. The other layers to be interposed are not particularly limited, however, these layers may be easily formed from a film made of a nonmagnetic material, such as an inorganic or organic material, for example.

Next, a piston position detection method of the magnetic sensor 40 in the piston position detector 31 according to the present embodiment will be described with reference to FIGS. 11A to 12B. The output of the magnetic sensor 40 is determined by a threshold magnetic flux density. In particular, the output voltage is in the high level state with the magnetic flux density being low and is the low level state with magnetic flux density being high. Accordingly, a threshold is set for the output voltage of the magnetic sensor 40. Furthermore, the magnitude of the output of the magnetic sensor 40 is determined to be in the high level state with the output voltage thereof being larger than the threshold and determined to be in the low level state with the output voltage thereof being smaller than the threshold. Preferably, the threshold may be determined with a sufficient difference between the high and low level states for a clear distinguishment. In the present embodiment, the integrated circuit that performs the switching operation through comparison of the voltage values is used in combination with the output of the magneto-electric transducer. In this manner, the piston position detector 31 which detects the piston's position based on the external magnetic field can be obtained.

As shown in FIG. 11A, with no external magnetic field being applied, the bias magnetic field 45 is applied by the bias magnetic field applying member 43 to the magneto-resistive element 42 in the direction along the surface on which the magneto-resistive element 42 is formed. The bias magnetic field applying member 43 is magnetized in the direction along the surface on which the bias magnetic field applying member 43 is formed. The magnetic field 45 at this time has the high magnetic flux density near the magneto-resistive element 42 (indicated by a solid rightward arrow above the magneto-resistive element 42 in FIG. 11 A). As shown in FIG. 11B, if the threshold is set to determine the output voltage at this time to be the low level state, the output of the low level state will represent a state with no magnetic material 34 (i.e., the piston 33) being made to approach the magnetic sensor 40.

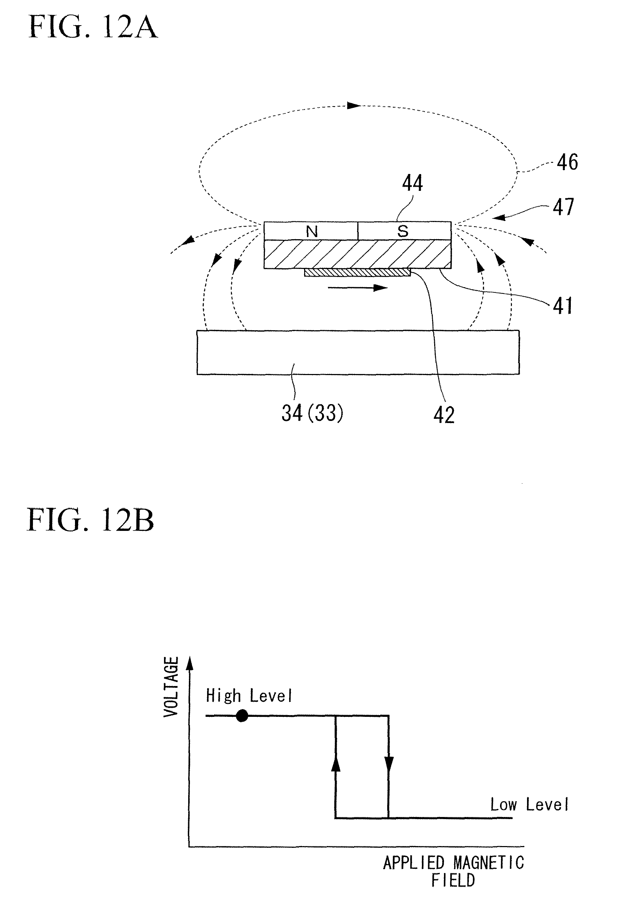

When the magnetic material 34 (i.e., the piston 33) is made to approach as shown in FIG 12A, the magnetic flux applied from the thin film magnet 44 will be absorbed by the magnetic material 34. As a result, the magnetic field 46 at this time has the low magnetic flux density near the magneto-resistive element 42 (indicated by a solid rightward arrow below the magneto-resistive element 42 in FIG. 12A). As shown in FIG. 12B, if the threshold is set to determine the output voltage at this time to be the high level state, the output of the high level state will represent a state with the magnetic material 34 (i.e., the piston 33) being made to approach the magnetic sensor 40.

The magneto-resistive element 42 has a resistance value which may vary according to the magnitude of magnetic field to be applied. The resistance value of the magneto-resistive element 42 decreases as the magnetic field to be applied becomes stronger. Thus, the potential difference (i.e., the bridge output) between two terminals of the magneto-resistive element 42 is increased or decreased depending on the magnitude of the magnetic flux density applied to the MR film. The bridge output is compared with a predetermined threshold to determine whether the output voltage is larger or smaller than the predetermined threshold, and then, the switching operation is performed in accordance with the comparison result. With this configuration, the magnetic sensor 40 which generates two different outputs according to the magnitude of the magnetic flux density applied to the magneto-resistive element 42, and a piston position detector 31 incorporating the same can be obtained. The output of the magnetic sensor 40 from the integrated circuit may be a signal indicating a high voltage value output when the bridge output of the magneto-resistive element 42 is smaller than the predetermined threshold, and a signal indicating a low voltage value output when the bridge output of the magneto-resistive element 42 is larger than the predetermined threshold. Alternatively, the output of the magnetic sensor 40 from the integrated circuit may be a signal indicating a low voltage value when the bridge output of the magneto-resistive element 42 is smaller than the predetermined threshold, and a signal indicating a high voltage value when the bridge output of the magneto-resistive element 42 is larger than the predetermined threshold.

Furthermore, since the integrated circuit (IC) mounted on the semiconductor substrate 41 performs the piston's position detection, the circuit required for comparison and control can be formed in a small space, which may provide a compact magnetic sensor 40.

Although the piston position detector 31 according to the second embodiment of the present invention has been described, the present invention is not limited to the same and may be suitably changed without departing from the spirit or scope of the present invention.

### Industrial Applicability

The magnetic sensor module according to an embodiment of the present invention may be used for various applications to detect approaching of a magnetic material, such as an iron sheet. An embodiment of the present invention may also be applied to a piston position detector.

## Claims

1. A magnetic sensor module comprising:
a semiconductor substrate including an integrated circuit for switching operation;
a magneto-resistive element which is disposed on a first surface of the semiconductor substrate and has a magneto-sensitive direction in a direction along the first surface; and
a bias magnetic field applying member provided on the semiconductor substrate and disposed on a surface which is parallel to the first surface,
wherein:
the bias magnetic field applying member is magnetized in a direction along the surface on which the bias magnetic field applying member is disposed; and
in a state with no external magnetic field is applied, the bias magnetic field applying member applies a bias magnetic field in the direction along the first surface on which the magneto-resistive element is provided.

2. A magnetic sensor module according to claim 1 wherein the bias magnetic field applying member is a pasted magnet or a thin film magnet.

3. A magnetic sensor module according to claim 2, wherein the integrated circuit compares output voltage of the magneto-resistive element with a predetermined threshold and outputs a signal indicating that the output voltage of the magneto-resistive element being larger than the predetermined threshold, i.e., in a high level state, or a signal indicating that the output voltage of the magneto-resistive element being smaller than the predetermined threshold, i.e., in a low level state, according to a comparison result.

4. A magnetic sensor module according to claim 3 wherein the bias magnetic field applying member is disposed on another surface opposite to the first surface of the semiconductor substrate.

5. A piston position detector comprising:
a cylinder tube made of a nonmagnetic material;
a piston at least partially made of a magnetic material and is disposed to slide on an inner circumferential surface of the cylinder tube; and
a magnetic sensor which is arranged on an outer circumferential surface of the cylinder tube and includes a bias magnetic field applying member.

6. A piston position detector according to claim 5, wherein:
the magnetic sensor includes at least an integrated circuit which performs a switching operation based on the magnitude of the magnetic flux density; and
the bias magnetic field applying member is a thin film magnet which is disposed on an upper surface, a lower surface, or an inside of the integrated circuit.

7. A piston position detector according to claim 5, wherein:
the magnetic sensor comprising a semiconductor substrate and a magneto-resistive element which is disposed on a first surface of the semiconductor substrate and has a magneto-sensitive direction in the direction along the first surface;
the bias magnetic field applying member is a magnet which is provided on the semiconductor substrate and is disposed on a surface which is parallel to the first surface;
the magnet is magnetized in the direction along the surface on which the magnet is disposed; and
in a state with no external magnetic field is applied, the magnet applies a bias magnetic field in a direction along the first surface on which the magneto-resistive element is provided.
